# EUROPÄISCHE PATENTSCHRIFT

(11) **EP 1 932 002 B1**
(45) Veröffentlichungstag und Bekanntmachung des Hinweises auf die Patenterteilung: **26.08.2009**
(21) Anmeldenummer: 06805909.6
(22) Anmeldetag: 27.09.2006
(51) Int. Cl.: G01R 1/067

(54) **TASTKOPF MIT WECHSELEINRICHTUNG**
PROBE WITH A CHANGING DEVICE
TETE DE DETECTION A MECANISME DE PERMUTATION

(30) Priorität: 04.10.2005 DE 102005047483
(43) Veröffentlichungstag der Anmeldung: 18.06.2008
(73) Patentinhaber: Rohde & Schwarz GmbH & Co. KG, 81671 München (DE)
(72) Erfinder: PESCHKE, Martin, 81739 München (DE)
(74) Vertreter: Körfer, Thomas
(86) Internationale Anmeldenummer: PCT/EP2006/009389
(87) Internationale Veröffentlichungsnummer: WO 2007/039204

(56) Entgegenhaltungen:
- EP-A2- 1 160 575
- DE-A1- 4 417 580
- DE-C1- 4 319 643
- GB-A- 2 316 534
- US-A1- 2003 195 713
- US-B1- 6 307 363
- US-B1- 6 366 103
- US-B1- 6 400 167

## Beschreibung

Die vorliegende Erfindung bezieht sich auf einen Tastkopf mit einer Wechseleinrichtung für ein Messgerät, insbesondere ein Oszilloskop.

Spannungstastköpfe für Oszilloskope sind in verschiedenen Varianten erhältlich. Für hochfrequente Signale jenseits von 1GHz werden hauptsächlich aktive Tastköpfe eingesetzt, wohingegen passive Wellenleitertastköpfe eine preisgünstige Alternative bieten. Bei den passiven Wellenleitertastköpfen ist der Testpunkt direkt an den mit 50Ω terminierten Wellenleiter angeschlossen, wodurch die zu messende Schaltung aufgrund des geringen Widerstands von 50Ω belastet ist.

Aus EP1 160 575 A2 ist ein Tastkopf mit einer Wechseleinrichtung für die Messspitzen bekannt. Aus DE 44 17 580 A1 ist ein Roboten gesteuerter Tastkopf mit einer drehenden Wechseleinrichtung für die Messspitzen bekannt.

Aus der DE 41 40 506 A1 ist ein Hochspannungsabtastkopf bekannt, der ein Hochfrequenz-Koaxialkabel aufweist, das mit seinem Wellenwiderstand über den größten Teil des Hochfrequenzbereiches abgeschlossen ist. Ferner ist in dem in der DE 41 40 506 A1 beschriebenen Hochspannungsabtastkopf eine Schaltung mit Widerständen und Kondensatoren vorgesehen, die ein festes Teilerverhältnis unabhängig von der Eingangsfrequenz bereitstellen. Die in der DE 41 40 506 A1 beschriebenen Ausführungsbeispiele decken insgesamt einen Messbereich von 0 Hz (Gleichstrom) bis über 100 MHz (Hochfrequenz) ab, wobei dieser Bereich in vier Teilmessbereiche unterteilt ist, so dass jedes Ausführungsbeispiel einen bestimmten Frequenzbereich abdeckt. Von Nachteil ist dabei, dass man beim Messen eines Frequenzbereichs, der von Gleichstrom (0 Hz) bis zu hochfrequenten Wechselströmen von über 100 MHz den Hochspannungsabtastkopf mehrmals austauschen muss. Außerdem ist bei den in der DE 41 40 506 A1 beschriebenen Hochspannungsabtastköpfen von Nachteil, dass sie aufgrund des hohen Spannungsteilerverhältnisses dafür ausgelegt sind, Spannungen im Bereich von mehreren zehntausend Volt zu messen. Eine angelegte Spannung von ungefähr 1 Volt würde von diesen Hochspannungsabtastköpfen nicht mehr mit ausreichender Genauigkeit erfasst werden.

Der Erfindung liegt daher die Aufgabe zu Grunde, einen Tastkopf zu schaffen, der einen großen Frequenzbereich abdeckt und dessen zu erfassender Spannungsbereich während der Messung schnell und flexibel erweitert bzw. eingeschränkt werden kann, so dass mit einem Tastkopf sowohl ein großer Frequenzbereich als auch ein großer Spannungsbereich messtechnisch erfasst werden können.

Diese Aufgabe wird erfindungsgemäß durch die in den Ansprüchen und 23 beschriebenen Tastköpfe gelöst. Vorteilhafte Weiterbildungen der Erfindung sind in den Unteransprüchen angegeben.

Ein Vorteil des erfindungsgemäßen Tastkopfs liegt darin, dass der Tastkopf zumindest zwei Messspitzen aufweist, die in einer mit dem Tastkopf verbundenen Wechseleinrichtung vorgesehenen sind. Die Messspitzen können wahlweise mit einem innerhalb des Tastkopfs verlaufenden elektrischen Wellenleiter verbunden werden, so dass Spannungen nahe einer Messbereichsgrenze komfortabel und ohne einen vollständigen Austausch der Messspitze untersucht werden können.

Ein weiterer Vorteil einer Weiterbildung des erfindungsgemäßen Tastkopfes ist, dass der elektrische Wellenleiter ein Koaxialleiter ist, wodurch gewährleistet ist, dass der erfindungsgemäße Tastkopf am Messpunkt einen großen Frequenzbereich erfassen kann.

Weiter ist es von Vorteil, dass der erfindungsgemäße Tastkopf einfach aufgebaut und robust gegen Überspannungen, Temperaturschwankungen und mechanische Belastung ist.

Ein weiterer Vorteil des erfindungsgemäßen Tastkopfs besteht darin, dass die zu messende Schaltung aufgrund der in den Messspitzen vorgesehenen Spannungsteiler weniger belastet wird. Die Messgenauigkeit ist somit erhöht.

Weiterhin ist von Vorteil, dass die Vorwiderstände nicht mehr manuell aufgesteckt werden müssen, da sie bereits in den in der Wechseleinrichtung vorgesehenen Messspitzen integriert sind.

Wenn in den Messspitzen des erfindungsgemäßen Tastkopfs Erkennungswiderstände vorgesehen sind, die über eine Erkennungsleitung mit dem Eingang des Messgeräts verbunden sind, entfällt vorteilhafterweise für den Benutzer die manuelle Korrektur der Anzeigewerte am Messgerät bei einem Wechsel der Messspitze. Die Anzeigewerte werden automatisch skaliert, da dem angeschlossenen Messgerät über die Erkennungsleitung der Wert der Spannungsteilung in der aktuell verwendeten Messspitze mitgeteilt wird.

Zusätzlich von Vorteil ist, dass die nicht aktive Messspitze, die zur Seite gedreht wurde, nun als Stützpunkt für die Finger des Benutzers dienen kann. Außerdem behindern die nicht benutzten Messspitzen nicht die Adaption der aktiven Messspitze.

Ein Ausführungsbeispiel der Erfindung wird nachfolgend unter Bezugnahme auf die Zeichnung näher beschrieben. In der Zeichnung zeigen:
- Fig. 1: einen Schnitt durch einen erfindungsgemäßen Tastkopf;
- Fig. 2: einen Schnitt durch einen erfindungsgemäßen Tastkopf mit einer Messspitze im kontaktierten Zustand;
- Fig. 3: einen Schnitt durch einen erfindungsgemäßen Tastkopf mit einer Messspitze im nicht kontaktierten Zustand;
- Fig. 4: einen Schnitt durch einen Wechselvorgang der Messspitzen bei einem erfindungsgemäßen Tastkopf;
- Fig. 5: eine schematische Darstellung eines Ausführungsbeispiels eines erfindungsgemäßen Tastkopfs mit einer Messspitze im kontaktierten Zustand und
- Fig. 6: eine schematische Darstellung eines Ausführungsbeispiels eines erfindungsgemäßen Tastkopfs mit einer Messspitze für einen größeren Messbereich im kontaktierten Zustand.

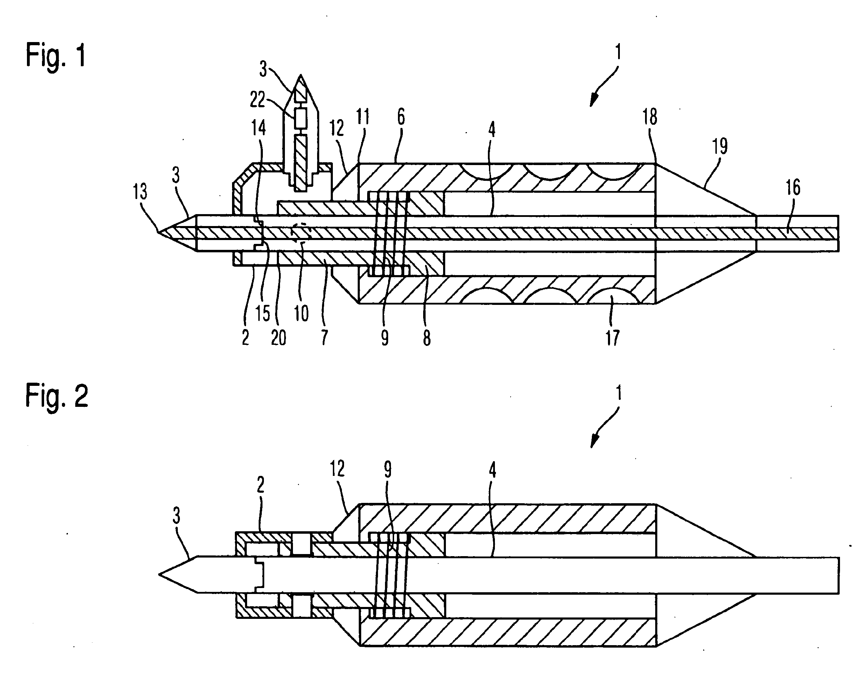

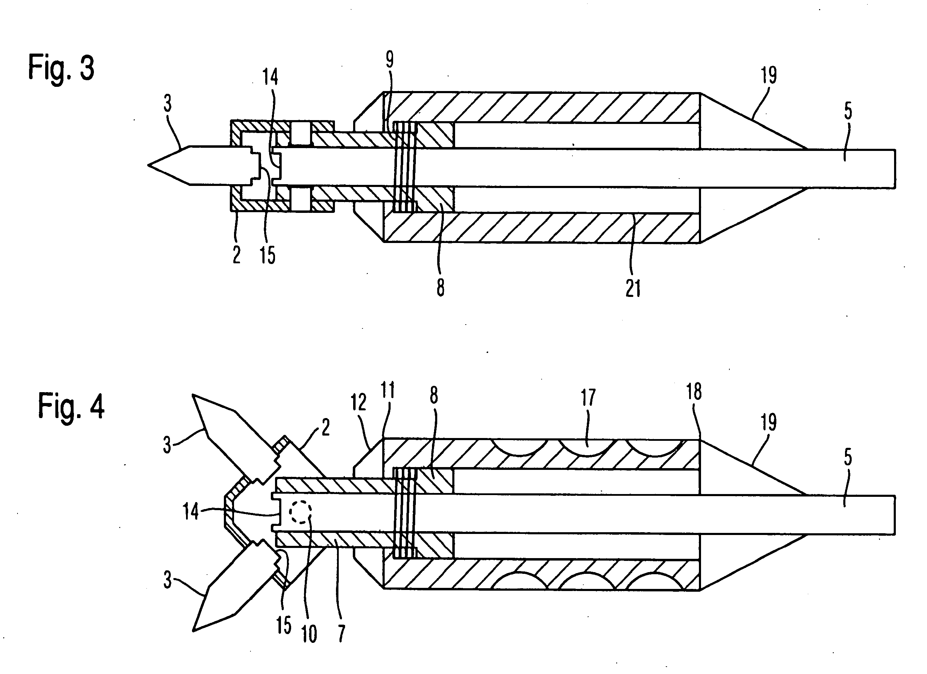

Fig. 1 zeigt einen Schnitt durch einen erfindungsgemäßen Tastkopf 1, der an ein Messgerät, wie z.B. ein Oszilloskop oder einen Netzwerkanalysator angeschlossen werden kann. Der erfindungsgemäße Tastkopf 1 weist zumindest zwei Messspitzen 3 auf, die in einer mit dem Tastkopf 1 verbundenen Wechseleinrichtung 2 angeordnet sind. Diese Messspitzen 3 sind wahlweise mit einem innerhalb des Tastkopfes 1 verlaufenden elektrischen Wellenleiter 4, insbesondere einer Koaxialleitung 5 (siehe Fig.4), verbindbar.

Der erfindungsgemäße Tastkopf 1 weist einen aus nicht leitenden Material, vorzugsweise aus Kunststoff gefertigten Tastkopfkörper 6 auf, in dem radiale Rillen 17 angebracht sind, die bei einer manuellen Bedienung des Tastkopfes 1 ein Abrutschen der Hand des Bedieners verhindern sollen.

In seinem Inneren weist der Tastkopfkörper 6 eine zylinderförmige Führung 21 (siehe Fig.3) auf. Entlang der zylinderförmigen Führung 21 ist eine Hülse 7 axial verschieblich, wobei diese Hülse 7 einen Teil des im Inneren des Tastkopfes 1 verlaufenden Wellenleiters 4 umfasst. Die Hülse 7, die an einem ersten Ende 11 des Tastkopfkörpers 6 aus diesem herausragt, weist einen, sich im Inneren des Tastkopfkörpers 6 befindlichen Flansch 8 auf. An diesem Flansch 8 stützt sich eine Feder 9 ab, die die Hülse 7 konzentrisch umgibt. Die Zugkraft der Feder 9 bewirkt, dass die Wechseleinrichtung 2 an einer an einem ersten Ende 11 des Tastkopfkörpers 6 angebrachten ersten Kappe 12 in einem arretierten Zustand anliegt. An einem zweiten Ende 18 des Tastkopfkörpers 6, das einem anzuschließenden Messgerät zugewandt ist, ist eine zweite Kappe 19 angebracht, die als Schutz vor Verschmutzung der zylinderförmigen Führung 21 im Inneren des Tastkopfkörpers 6 dient.

Der erfindungsgemäße Tastkopf 1 weist eine austauschbare Wechseleinrichtung 2 auf, die um eine Achse 10 in einem aus dem Tastkopfkörper 6 herausragenden Ende der den Wellenleiter umfassenden Hülse 7 drehbar ist. Die in der Wechseleinrichtung 2 vorgesehenen und verschraubten Messspitzen 3 sind ebenfalls austauschbar.

Die Wechseleinrichtung 2 weist eine Ausnehmung 20 auf, in die die aus dem Tastkopfkörper 6 herausragende Hülse 7 hineingreift, wobei die Wechseleinrichtung 2 an ihrem aus dem Tastkopfkörper 6 herausragenden Ende befestigt ist.

Der in der Hülse 7 gehaltene Wellenleiter 4 weist an einem zu einem Messpunkt 13 zugewandten Ende eine Ausnehmung 14 auf, die als Steckkontakt dient. Der zugehörige Stecker ergibt sich durch eine komplementär zu der Ausnehmung geformte Erhöhung 15 an der Messspitze 3. Diese Erhöhung 15, die einen Innenleiter 16 der Koaxialleitung 5 umfasst, ist an einer einem Messpunkt 13 abgewandten Ende der Messspitze 3 vorgesehen. Es kann auch jede bekannte Art von HF-Steckverbindung, insbesondere BMA, SMB, verwendet werden.

Fig. 2 zeigt eine Draufsicht auf einen erfindungsgemäßen Tastkopf 1 mit einer Messspitze 3 im kontaktierten Zustand, wobei die weiteren Messspitzen, die an der Wechseleinrichtung 2 befestigt sind, in dieser Darstellung nicht sichtbar sind. Die kontaktierte Messspitze 3 ist auf dem Wellenleiter 4 aufgesteckt, wobei dieser Steckkontakt mit der Kraft der Feder 9, die sich im Inneren der zylindrischen Führung 21 befindet, beaufschlagt ist.

Fig. 3 zeigt eine Draufsicht auf einen erfindungsgemäßen Tastkopf 1 mit einer Messspitze 3 im nicht kontaktierten Zustand. Die Messspitze 3 wird aus dem mit der Zugkraft der Feder 9 beaufschlagten Steckkontakt gelöst, indem gegen die Druckkraft der Feder 9 gezogen wird. In diesem Zustand kann die gerade im Gebrauch gewesene Messspitze 3 gegen eine zweite, auf der Wechseleinrichtung 2 befestigte Messspitze 3 ausgewechselt werden, indem die zweite Messspitze 3 in die richtige Position gedreht wird und so ausgerichtet wird, dass bei einer kräftemäßigen Entlastung der drehbaren Wechseleinrichtung 2 die ausgewechselte Messspitze 3 in den Kontakt einrastet.

Fig. 4 zeigt eine Draufsicht auf den Wechselvorgang der Messspitzen 3 bei einem erfindungsgemäßen Tastkopf 1. Keine der beiden auf der drehbaren Wechseleinrichtung 2 vorgesehenen Messspitzen 3 ist in den Steckkontakt eingerastet. Ein Einrasten einer der beiden Messspitzen 3 kommt dadurch zustande, dass die Wechseleinrichtung 2 entweder weiter gegen den Uhrzeigersinn bzw. mit dem Uhrzeigersinn gedreht wird.

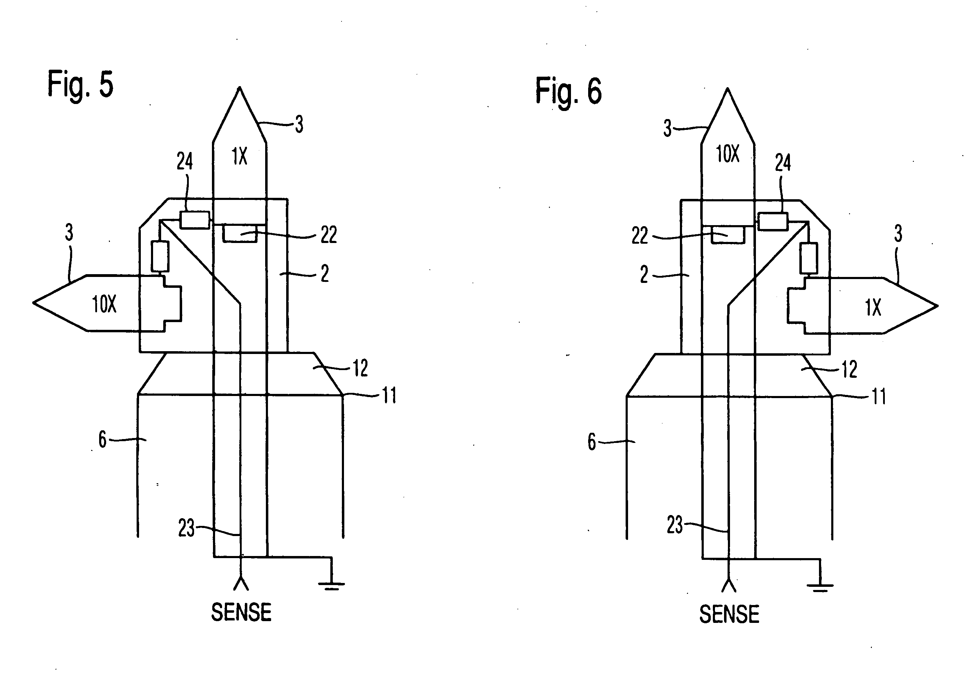

Fig. 5 zeigt eine schematische Darstellung eines Ausführungsbeispiels eines erfindungsgemäßen Tastkopfs 1 mit einer Messspitze 3 im kontaktierten Zustand. Innerhalb der Wechseleinrichtung 2 des erfindungsgemäßen Tastkopfs 1 ist pro Messspitze 3 ein mit einer Erkennungsleitung 23 verbundener Erkennungswiderstand 24 vorgesehen. Die Erkennungswiderstände 24 sind zwischen der Erkennungsleitung 23 und den Außenleitermassen der einzelnen Messspitzen 3 angeordnet. Wird die Erkennungsleitung 23 über einen zusätzlichen Pin z. B. mit einem Oszilloskop verbunden, so wird beim Wechseln der Messspitze 3 automatisch ein Umschalten der Anzeigeskalierung des Oszilloskops bewirkt.

Fig. 6 zeigt eine schematische Darstellung eines Ausführungsbeispiels eines erfindungsgemäßen Tastkopfs 1 mit einer Messspitze 3 für einen höheren Spannungsbereich im kontaktierten Zustand. Dadurch, dass der Eingang des Messgeräts über die Erkennungsleitung 23 mit dem Erkennungswiderstand 24 verbunden ist, kann sich die. Anzeige nun automatisch auf den höheren Spannungsbereich skalieren. Die beiden in der Wechseleinrichtung 2 vorgesehenen Messspitzen 3 unterscheiden sich durch einen innerhalb der Messspitze vorgesehenen Teilerwiderstand 22, der den zu messenden Spannungsbereich definiert.

Die Erfindung ist nicht auf das dargestellte Ausführungsbeispiel bzw. die beschriebenen Ausführungsbeispiele beschränkt, sondern durch die Ansprüche definiert, und kann z.B. sowohl an einem Oszilloskop, einem Signalgenerator oder an einem Netzwerkanalysator Anwendung finden.

## Patentansprüche

1. Tastkopf (1) mit zumindest zwei an einer mit dem Tastkopf (1) verbundenen Wechseleinrichtung (2) angeordneten Messspitzen (3), die wechselweise mit einem innerhalb des Tastkopfs (1) verlaufenden elektrischen Wellenleiter (4) verbindbar sind, **dadurch gekennzeichnet, dass** der Wellenleiter (4) von einer in einem Tastkopfkörper (6) axial gegen eine Feder (9) verschieblichen Hülse (7) umgeben ist, und wobei die Wechseleinrichtung (2) um eine Achse (10) in einem aus dem Tastkopfkörper (6) herausragenden Ende der Hülse (7) drehbar ist.

2. Tastkopf nach Anspruch 1,
**dadurch gekennzeichnet,**
**dass** der Wellenleiter (4) eine Koaxialleitung (5) ist.

3. Tastkopf nach Anspruch 1 oder 2,
**dadurch gekennzeichnet,**
**dass** die Hülse (7) einen Flansch (8) aufweist.

4. Tastkopf nach Anspruch 3,
**dadurch gekennzeichnet,**
**dass** an dem Flansch (8) der Hülse (7) die Feder (9) angreift.

5. Tastkopf nach einem der Ansprüche 1 bis 4,
**dadurch gekennzeichnet,**
**dass** die Messspitzen (3) in der Wechseleinrichtung (2) austauschbar sind.

6. Tastkopf nach einem der Ansprüche 1 bis 5,
**dadurch gekennzeichnet,**
**dass** die Messspitzen (3) in der Wechseleinrichtung (2) verschraubt sind.

7. Tastkopf nach einem der Ansprüche 1 bis 6,
**dadurch gekennzeichnet,**
**dass** die Wechseleinrichtung (2) austauschbar ist.

8. Tastkopf nach einem der Ansprüche 1 bis 7,
**dadurch gekennzeichnet,**
**dass** die Wechseleinrichtung (2) an einer an einem ersten Ende (11) des Tastkopfkörpers (6) angebrachten ersten Kappe (12) in einem arretierten Zustand anliegt.

9. Tastkopf nach einem der Ansprüche 1 bis 4,
**dadurch gekennzeichnet,**
**dass** die Wechseleinrichtung (2) eine Ausnehmung (20) aufweist, in die die aus dem Tastkopfkörper (6) herausragende Hülse (7) hineingreift.

10. Tastkopf nach Anspruch 9,
**dadurch gekennzeichnet**,
die Wechseleinrichtung (2) mittels einer an der Hülse (7) angreifenden Feder (9) arretiert ist.

11. Tastkopf nach einem der Ansprüche 1 bis 10,
**dadurch gekennzeichnet,**
**dass** der in der Hülse (7) gehaltene Wellenleiter (4) an einem zu einem Messpunkt (13) zugewandten Ende eine Ausnehmung (14) aufweist.

12. Tastkopf nach Anspruch 11,
**dadurch gekennzeichnet,**
**dass** die Messspitzen (3) an einem dem Messpunkt (13) abgewandten Ende eine komplementär zur Ausnehmung (14) im Wellenleiter (4) geformte Erhöhung (15) aufweist.

13. Tastkopf nach Anspruch 12,
**dadurch gekennzeichnet,**
**dass** in der Erhöhung (15) ein Innenleiter (16) eines Koaxialkabels (5) verläuft.

14. Tastkopf nach einem der Ansprüche 1 bis 13,
**dadurch gekennzeichnet,**
**dass** der Tastkopfkörper (6) radial angebrachte Rillen (17) aufweist.

15. Tastkopf nach Anspruch 14,
**dadurch gekennzeichnet,**
**dass** der Tastkopfkörper (6) aus nicht leitendem Material, vorzugsweise aus Kunststoff besteht.

16. Tastkopf nach Anspruch 14 oder 15,
**dadurch gekennzeichnet,**
**dass** der Tastkopfkörper (6) an einem zweiten Ende (18), das einem anzuschließenden Messgerät zugewandt ist, eine zweite Kappe (19) aufweist.

17. Tastkopf nach einem der Ansprüche 1 bis 16,
**dadurch gekennzeichnet,**
**dass** der Tastkopfkörper (6) in seinem Inneren eine Führung (21) aufweist.

18. Tastkopf nach Anspruch 17,
**dadurch gekennzeichnet,**
**dass** die Hülse (7) entlang der Führung (21) axial verschieblich ist.

19. Tastkopf nach einem der Ansprüche 1 bis 18,
**dadurch gekennzeichnet,**
**dass** eine nicht aktive Messspitze (3) als Griffelement vorgesehen ist, wobei die nicht aktive Messspitze (3) keine Verbindung zum elektrischen Wellenleiter (4) hat.

20. Tastkopf nach einem der Ansprüche 1 bis 19,
**dadurch gekennzeichnet,**
**dass** innerhalb jeder Messspitze (3) ein Teilerwiderstand (22) vorgesehen ist.

21. Tastkopf nach einem der Ansprüche 1 bis 20,
**dadurch gekennzeichnet,**
**dass** innerhalb der Wechseleinrichtung (2) pro Messspitze (3) ein mit einer Erkennungsleitung (23) verbundenes Erkennungselement (24) vorgesehen ist.

22. Tastkopf nach Anspruch 21,
**dadurch gekennzeichnet,**
**dass** das Erkennungselement ein Erkennungswiderstand (24) ist und
**dass** die am Erkennungswiderstand (24) abfallende Spannung zur automatischen Skalierung einer am angeschlossenen Messgerät vorgesehenen Messanzeige dient.

23. Tastkopf (1) mit zumindest zwei an einer mit dem Tastkopf (1) verbundenen Wechseleinrichtung (2) angeordneten Messspitzen (3), die wechselweise mit einem innerhalb des Tastkopfs (1) verlaufenden elektrischen Wellenleiter (4) verbindbar sind,
**dadurch gekennzeichnet,**
**dass** zumindest eine zur Seite gedrehte, nicht aktive Messspitze (3) als Stützelement für die Finger eines Benutzers vorgesehen ist, wobei die nicht aktive Messspitze (3) keine Verbindung zum elektrischen Wellenleiter (4) hat.

## Claims

1. Probe (1) with at least two probe tips (3), which can be connected alternately to an electrical waveguide (4) extending within the probe (1) and are mounted on a changeover device (2) connected to the probe (1),
**characterised in that**
the waveguide (4) is surrounded by a sleeve (7) axially displaceable within a probe body (6) against a spring (9), and
wherein the changeover device (2) can be rotated about an axis (10) within an end of the sleeve (7) projecting from the probe body (6).

2. Probe according to claim 1,
**characterised in that**
the waveguide (4) is a coaxial line (5).

3. Probe according to claim 1 or 2,
**characterised in that**
the sleeve (7) provides a flange (8).

4. Probe according to claim 3,
**characterised in that**
the spring (9) engages on the flange (8) of the sleeve (7).

5. Probe according to any one of claims 1 to 4,
**characterised in that**
the probe tips (3) in the changeover device (2) are replaceable.

6. Probe according to any one of claims 1 to 5,
**characterised in that**
the probe tips (3) are screwed into the changeover device (2).

7. Probe according to any one of claims 1 to 6,
**characterised in that**
the changeover device (2) is replaceable.

8. Probe according to any one of claims 1 to 7,
**characterised in that**,
in a locked condition, the changeover device (2) is in contact with a first cap (12) disposed at a first end (11) of the probe body (6).

9. Probe according to any one of claims 1 to 4,
**characterised in that**
the changeover device (2) provides a recess (20), into which the sleeve (7) projecting from the probe body (6) engages.

10. Probe according to claim 9,
**characterised in that**
the changeover device (2) is locked by means of a spring (9) engaging on the sleeve (7).

11. Probe according to any one of claims 1 to 10,
**characterised in that**
the waveguide (4) held within the sleeve (7) provides a recess (14) at an end facing towards a testing point (13).

12. Probe according to claim 11,
**characterised in that**,
at an end facing away from the testing point (13), the probe tips (3) provide a protuberance (15) complementary to the recess (14) in the waveguide (4).

13. Probe according to claim 12,
**characterised in that**
an inner conductor (16) of a coaxial cable (5) extends within the protuberance (15).

14. Probe according to any one of claims 1 to 13,
**characterised in that**
the probe body (6) provides radially-arranged grooves (17).

15. Probe according to claim 14,
**characterised in that**
the probe body (6) consists of nonconductive material, preferably synthetic material.

16. Probe according to claim 14 or 15,
**characterised in that**
the probe body (6) provides a second cap (19) at a second end (18), which faces towards a test device to be connected.

17. Probe according to any one of claims 1 to 16,
**characterised in that**
the probe body (6) provides a guide (21) in its interior.

18. Probe according to claim 17,
**characterised in that**
the sleeve (7) is axially displaceable along the guide (21).

19. Probe according to any one of claims 1 to 18,
**characterised in that**
a non-active probe tip (3) is provided as a grip element, wherein the non-active probe tip (3) has no connection to the electrical waveguide (4).

20. Probe according to any one of claims 1 to 19,
**characterised in that**
a divider resistor (22) is provided within each probe tip (3).

21. Probe according to any one of claims 1 to 20,
**characterised in that**,
within the changeover device (2), one detection element (24) connected to a detection line (23) is provided for each probe tip (3).

22. Probe according to claim 21,
**characterised in that**
the detection element is a detection resistor (24) and
that the voltage occurring at the detection resistor (24) serves for the automatic scaling of a test display provided in the connected measuring device.

23. Probe (1) with at least two probe tips (3), which can be connected alternately to an electrical waveguide (4) extending within the probe (1) and are disposed on a changeover device (2) connected to the probe (1),
**characterised in that**
at least one non-active probe tip (3) rotated to the side is provided as a supporting element for a user's fingers, wherein the non-active probe tip (3) has no connection to the electrical waveguide (4).

## Revendications

1. Tête de détection (1) comprenant au moins deux pointeaux de mesure (3), qui sont agencés sur un dispositif de permutation (2) lié à la tête de détection (1), et peuvent être reliés alternativement à un guide d'onde électrique (4) s'étendant à l'intérieur de la tête de détection (1),
**caractérisée en ce que** le guide d'onde électrique (4) est entouré par une douille (7) pouvant coulisser axialement, à l'encontre d'un ressort (9), dans un corps de tête de détection (6), et le dispositif de permutation (2) peut tourner autour d'un axe (10) dans une extrémité de la douille (7), qui fait saillie hors du corps de tête de détection (6).

2. Tête de détection selon la revendication 1,
**caractérisée en ce que** le guide d'onde (4) est un conducteur coaxial (5).

3. Tête de détection selon la revendication 1 ou 2,
**caractérisée en ce que** la douille (7) comporte un flasque (8).

4. Tête de détection selon la revendication 3,
**caractérisée en ce que** le ressort (9) agit sur le flasque (8) de la douille (7).

5. Tête de détection selon l'une des revendications 1 à 4,
**caractérisée en ce que** les pointeaux de mesure (3) sont interchangeables dans le dispositif de permutation (2).

6. Tête de détection selon l'une des revendications 1 à 5,
**caractérisée en ce que** les pointeaux de mesure (3) sont vissés dans le dispositif de permutation (2).

7. Tête de détection selon l'une des revendications 1 à 6,
**caractérisée en ce que** le dispositif de permutation (2) est interchangeable.

8. Tête de détection selon l'une des revendications 1 à 7,
**caractérisée en ce que** le dispositif de permutation (2) s'appuie, dans un état bloqué, contre un premier cabochon (12) placé à une première extrémité (11) du corps de tête de détection (6).

9. Tête de détection selon l'une des revendications 1 à 4,
**caractérisée en ce que** le dispositif de permutation (2) présente un évidement (20) dans lequel s'engage la douille (7) faisant saillie hors du corps de tête de détection (6).

10. Tête de détection selon la revendication 9,
**caractérisée en ce que** le dispositif de permutation (2) est bloqué au moyen d'un ressort (9) agissant sur la douille (7).

11. Tête de détection selon l'une des revendications 1 à 10,
**caractérisée en ce que** le guide d'onde (4) maintenu dans la douille (7) présente un évidement (14) à une extrémité dirigée vers un point de mesure (13).

12. Tête de détection selon la revendication 11,
**caractérisée en ce que** les pointeaux de mesure (3) présentent, au niveau d'une extrémité opposée à celle dirigée vers le point de mesure (13), une protubérance (15) formée de manière complémentaire à l'évidement (14) dans le guide d'onde (4).

13. Tête de détection selon la revendication 12,
**caractérisée en ce que** dans la protubérance (15) s'étend un conducteur intérieur (16) d'un câble coaxial (5).

14. Tête de détection selon l'une des revendications 1 à 13,
**caractérisée en ce que** le corps de tête de détection (6) présente des rainures (17) agencées radialement.

15. Tête de détection selon la revendication 14,
**caractérisée en ce que** le corps de tête de détection (6) est réalisé en un matériau non conducteur, de préférence en matière plastique.

16. Tête de détection selon la revendication 14 ou 15,
**caractérisée en ce que** le corps de tête de détection (6) présente, au niveau d'une deuxième extrémité (18) qui est dirigée vers un appareil de mesure à y raccorder, un deuxième cabochon (19).

17. Tête de détection selon l'une des revendications 1 à 16,
**caractérisée en ce que** le corps de tête de détection (6) comporte en son intérieur, un guidage (21).

18. Tête de détection selon la revendication 17,
**caractérisée en ce que** la douille (7) peut coulisser axialement le long du guidage (21).

19. Tête de détection selon l'une des revendications 1 à 18,
**caractérisée en ce qu'**un pointeau de mesure (3) non actif est prévu en tant qu'élément de préhension, le pointeau de mesure (3) non actif ne présentant pas de liaison avec le guide d'onde électrique (4).

20. Tête de détection selon l'une des revendications 1 à 19,
**caractérisée en ce qu'**à l'intérieur de chaque pointeau de mesure (3) est prévue une résistance de division (22) .

21. Tête de détection selon l'une des revendications 1 à 20,
**caractérisée en ce qu'**à l'intérieur du dispositif de permutation (2) est prévu, par pointeau de mesure (3), un élément d'identification (24) relié à un conducteur d'identification (23).

22. Tête de détection selon la revendication 21,
**caractérisée en ce que** l'élément d'identification est une résistance d'identification (24), et **en ce que** la tension chutant au niveau de la résistance d'identification (24) sert à définir l'échelle d'un affichage de mesure prévu sur l'appareil de mesure raccordé.

23. Tête de détection (1) comprenant au moins deux pointeaux de mesure (3), qui sont agencés sur un dispositif de permutation (2) lié à la tête de détection (1), et peuvent être reliés alternativement à un guide d'onde électrique (4) s'étendant à l'intérieur de la tête de détection (1),
**caractérisée en ce qu'**au moins un pointeau de mesure (3) non actif, tourné vers le côté, est prévu en tant qu'élément d'appui pour les doigts d'un utilisateur, le pointeau de mesure (3) non actif n'ayant pas de liaison avec le guide d'onde électrique (4).
